# EUROPEAN PATENT APPLICATION

(11) **EP 4 657 425 A1**
(43) Date of publication of application: **03.12.2025**
(21) Application number: 25179338.6
(22) Date of filing: 28.05.2025
(51) Int. Cl.: G09G 5/393, G09G 5/395

(54) **DATA PROCESSING DEVICE AND MEMORY CONTROL METHOD OF DATA PROCESSING DEVICE**

(30) Priority: 29.05.2024 KR 20240070042
(71) Applicant: LX Semicon Co., Ltd., Daejeon 34027 (KR)
(72) Inventor: ROH, Jae Hong, 34027 Daejeon (KR)
(74) Representative: Ter Meer Steinmeister & Partner

(57) **Abstract**

The present disclosure relates to a data processing device and a memory control method of a data processing device, and in particular, to a data processing device and a memory control method of a data processing device that perform reading of previous previous frame data and writing of current frame data in one memory area.

## Description

This application claims priority to of Korean Patent Application No. 10-2024-0070042, filed May 29, 2024.

### BACKGROUND

### Field

The present embodiment relates to a data processing device and a memory control method of a data processing device.

### Discussion of Related Art

A display device such as an organic light-emitting display or a liquid crystal display may include a data processing device, a data driving device, a memory device, and a display panel, and the data processing device may be designed to process image data, control data, and clocks in the form of packets and provide the packets to the data driving device. Here, the data processing device may be referred to as a timing controller, and the data driving device may be referred to as a source driver.

In general, the data processing device may receive image data from a host. Here, the image data may be composed of a plurality of pieces of frame data.

To improve the image quality of the display device, the data processing device may correct the frame data. Then, the data processing device may provide the corrected frame data to the data driving device.

To smoothly correct the frame data, the data processing device may store current frame data received from the host in the memory device in a current frame period, read previous frame data stored in the memory device in a previous frame period, in the current frame period, and output the previous frame data to the data driving device.

Here, a memory area of the memory device may be divided into a first area and a second area. When the previous frame data is stored in the first area, the data processing device may store the current frame data in the second area and read the previous frame data stored in the first area.

As described above, in the related art, two memory areas are required for storing the current frame data and reading the previous frame data. For this reason, the capacity and size of the memory device increase, and the power consumption of the display increases due to the increase in capacity of the memory device.

### SUMMARY

From such a background, the present disclosure provides a technique for performing reading of previous frame data and writing of current frame data in one memory area.

The problems addressed by the present disclosure are not limited to those described above, and other problems not described will be clearly understood by those skilled in the art from the following description.

The object is solved by the features of the independent claims. Preferred embodiments are given in the dependent claims.

In one embodiment, there is provided a data processing device including a writing line buffer configured to temporarily store zero-th input line data included in current frame data in a current frame period defined as a high voltage level period of a vertical synchronization signal, a reading line buffer configured to output, in a state in which zero-th output line data to k-th (where k is a natural number equal to or greater than one) output line data included in previous frame data are stored in advance, the zero-th output line data when the writing line buffer temporarily stores the zero-th input line data in the current frame period, and a memory controller configured to sequentially read the zero-th output line data to the k-th output line data stored in a memory area of a memory device to the reading line buffer and then write the zero-th input line data stored in the writing line buffer to the memory area.

In another aspect, there is provided a memory control method of a data processing device including temporarily storing zero-th input line data of current frame data in a writing line buffer in a zero-th data enable period of a current frame period, in a state in which zero-th output line data to k-th (where k is a natural number equal to or greater than one) output line data of previous frame data stored in a memory area of a memory device are read to a reading line buffer in advance, extracting the zero-th output line data from the reading line buffer in the zero-th data enable period, reading (k+1) pieces of output line data stored in the memory area to the reading line buffer in the zero-th data enable period, and writing the zero-th input line data temporarily stored in the writing line buffer to the memory area, the zero-th input line data being written to one memory address among memory addresses in the memory area from which the zero-th output line data to the k-th output line data are read in advance.

In one or more embodiments, the memory controller may be configured to sequentially read the zero-th output line data to the k-th output line data to the reading line buffer in a latter portion of a previous frame period that is a frame period just before the current frame period.

In one or more embodiments, the memory controller may be configured to temporarily store the zero-th input line data to the writing line buffer in a high voltage level period of a data enable signal input in the current frame period and write the zero-th input line data temporarily stored in the writing line buffer to the memory area when the data enable signal is switched to a low voltage level.

In one or more embodiments, the memory controller may be configured to write the zero-th input line data to a memory address in the memory area where the zero-th output line data is read.

In one or more embodiments, the memory controller may be configured to read (k+1)th output line data stored in the memory area to the reading line buffer in outputting the zero-th output line data from the reading line buffer.

In one or more embodiments, the reading line buffer may be a memory having a queue structure, and the zero-th output line data dequeues at a front, and the (k+1)th output line data enqueues at a rear.

In one or more embodiments, in the writing, the data processing device may write the zero-th input line data to a memory address in the memory area where the zero-th output line data is read.

In one or more embodiments, the memory control method of a data processing device may comprise after the writing: reading the zero-th input line data stored in the one memory address to the reading line buffer in a latter portion of the current frame period.

In one or more embodiments, the data processing device may read the zero-th input line data to the reading line buffer after resetting a read address of the memory area.

In another aspect a display device is provided comprising: a panel; a data driving device configured to transmit a data signal to the panel; a gate driving device configured to transmit a gate signal to the panel, and a data processing device controlling the data driving device and the gate driving device.

In one or more embodiments, the data processing device may comprise a writing line buffer configured to temporarily store zero-th input line data included in current frame data during a current frame period defined as a high voltage level period of a vertical synchronization signal; a reading line buffer configured to output, in a state in which zero-th output line data to k-th (where k is a natural number equal to or greater than one) output line data included in previous frame data are stored in advance, the zero-th output line data when the writing line buffer temporarily stores the zero-th input line data in the current frame period; and a memory controller configured to sequentially read the zero-th output line data to the k-th output line data stored in a memory area of a memory device to the reading line buffer and then write the zero-th input line data stored in the writing line buffer to the memory area.

As described above, according to the embodiments, since the data processing device performs reading of previous frame data and storing of current frame data in one memory area, the capacity and size of the memory device can be reduced.

Various and beneficial advantages and effects of the present disclosure are not limited to the above, and may be more easily understood in the course of describing specific embodiments of the present disclosure.

### BRIEF DESCRIPTION OF THE DRAWINGS

The above and other objects, features, and advantages of the present disclosure will become more apparent to those of ordinary skill in the art by describing exemplary embodiments thereof in detail with reference to the attached drawings, in which:
FIG. 1 is a configuration diagram of a display device according to an embodiment;
FIG. 2 is a configuration diagram of a data processing device according to the embodiment;
FIG. 3 is a diagram illustrating an operation method of a memory controller of the embodiment;
FIG. 4 is a diagram illustrating an operation of a writing line buffer in an early portion of a current frame period;
FIG. 5 is a diagram illustrating an operation of the writing line buffer in a latter portion of the current frame period;
FIGS. 6 to 8 are diagrams illustrating an operation of a reading line buffer in the early portion of the current frame period;
FIGS. 9 to 12 are diagrams illustrating an operation of the reading line buffer in the latter portion of the current frame period;
FIG. 13 is a diagram illustrating an operation of the data processing device according to the embodiment to output frame data in the current frame period;
FIGS. 14 to 16 are diagrams a configuration in which writing and reading of line data are performed together in a memory area of a memory device according to the embodiment;
FIG. 17 is a flowchart illustrating a process in which the data processing device according to the embodiment writes line data to the memory area of the memory device; and
FIG. 18 is a flowchart illustrating a process in which the data processing device according to the embodiment reads line data from the memory area of the memory device.

### DETAILED DESCRIPTION OF EXEMPLARY EMBODIMENTS

Hereinafter, some embodiments of the present disclosure will be described in detail with reference to the accompanying illustrative drawings. It should be noted that, in designating components of the drawings by reference numerals, the same components will be designated by the same reference numerals even when the components are shown in different drawings. Further, in the following description of the present disclosure, detailed descriptions of known functions and components incorporated herein will be omitted when it is determined that the description can make the subject matter of the present disclosure rather unclear.

Terms such as first, second, A, B, (a), and (b) may be used herein in describing components of the present disclosure. Each of these terms is not used to define essence, order, or sequence of a corresponding component, but is used merely to distinguish the corresponding component from other components. When it is described that a certain component is "connected", "coupled", or "joined" to another component, it should be understood that another component may be "connected", "coupled", or "joined" between components as well as that the component may be connected or joined directly to another component.

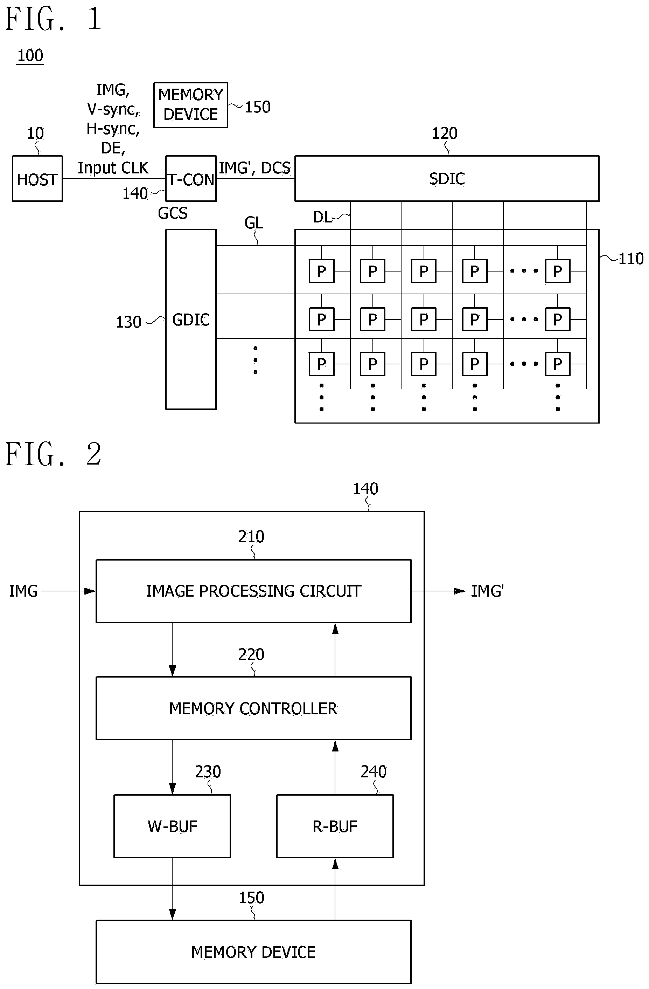

FIG. 1 is a configuration diagram of a display device according to an embodiment.

Referring to FIG. 1, a display device 100 may include a panel 110, a data driving device (source driver integrated circuit (SDIC) 120, a gate driving device (date driver integrated circuit (GDIC) 130, a data processing device (timing controller (T-CON) 140, and a memory device (MEMORY DEVICE) 150.

Here, one or more of the data driving device 120, the gate driving device 130, the data processing device 140, and the memory device 150 may be provided in one integrated circuit. Such an integrated circuit may be referred to as a display driver IC (DDI).

The data driving device 120 may drive data lines DL that are connected to pixels P, and the gate driving device 130 may drive gate lines GL that are connected to the pixels P.

In the panel 110, a plurality of data lines DL and a plurality of gate lines GL may be provided, and a plurality of pixels P may be provided. Here, each of the pixels P may include an organic light-emitting diode (OLED) and one or more transistors. The transistors may include one or more of a low temperature polycrystalline silicon (LTPS) transistor and a low temperature polycrystalline oxide (LTPO) transistor.

The data driving device 120 may supply a data voltage to the data line DL to display an image in each pixel P of the panel 110. The data driving device 120 may include at least one data driver integrated circuit, and at least one data driver integrated circuit may be connected to a bonding pad of the panel 110 by a tape automated bonding (TAB) method or a chip on glass (COG) method, may be formed directly in the panel 110, or may be incorporated and formed in the panel 110 in some cases. Further, the data driving device 120 may be implemented by a chip on film (COF) method.

The data driving device 120 may receive image data IMG' and a data control signal DCS from the data processing device 140. The data driving device 120 may generate a data voltage according to a grayscale value of each pixel indicated by the image data and drive each pixel.

The data control signal DCS may include at least synchronization signal. For example, the data control signal DCS may include a vertical synchronization signal V-sync and a horizontal synchronization signal H-sync.

The data driving device 120 may divide frames according to the vertical synchronization signal V-sync and drive each drive each pixel in a period other than a vertical blank period indicated by the vertical synchronization signal V-sync. The data driving device 120 may check image data by line according to the horizontal synchronization signal H-sync and supply a data voltage by line. Here, the line may means a horizontal line.

The gate driving device 130 may supply one or more scan signals to the gate line GL to turn on/off one or more transistors positioned in each pixel P. The gate driving device 130 may be positioned on one side of the panel 110 as in FIG. 1 or may be divided into two parts and positioned on both sides of the panel 110 according to a driving method. The gate driving device 130 may include at least one gate driver integrated circuit, and at least gate driver integrated circuit may be connected to a bonding pad of the panel 110 by a tape automated bonding (TAB) method or a chip on glass (COG) method, may be implemented as a gate in panel (GIP) type and formed directly in the panel 110, or may be integrated and formed in the panel 110 in some cases. Further, the gate driving device 130 may be implemented by a chip on film (COF) method.

The gate driving device 130 may receive a gate control signal GCS from the data processing device 140. The gate control signal GCS may include a plurality of gate clock signals. The gate driving device 130 may generate a scan signal using the gate clock signal and supply the scan signal to the gate line GL.

The data processing device 140 may receive timing signals such as the vertical synchronization signal V-sync, the horizontal synchronization signal H-sync, a data enable signal DE, and an input clock signal Input CLK input from a host 10 and synchronize the operation timings of the data driving device 120 and the gate driving device 130.

The data processing device 140 may receive image data IMG from the host 10 and convert the image data IMG into the image data IMG' in a form capable of being processed in the data driving device 120. The data processing device 140 may output the converted image data IMG' to the data driving device 120. Here, the image data IMG may be composed of a plurality of pieces of frame data. Then, one piece of frame data may include a plurality of pieces of line data.

In the embodiment, the data processing device 140 may perform writing of current frame data and reading of previous frame data together in one memory area of the memory device 150.

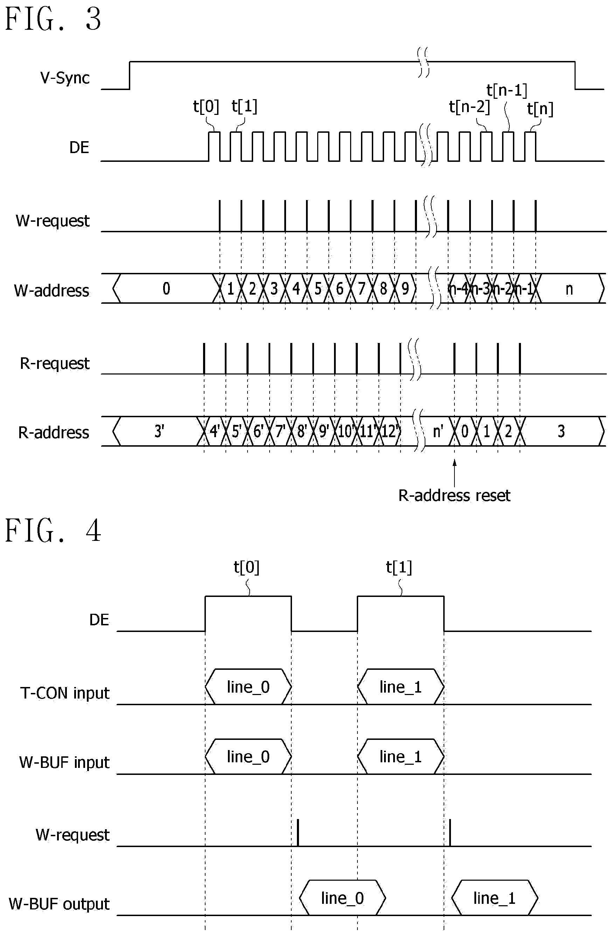

In other words, the data processing device 140 may sequentially write zero-th input line data to n-th (where n is a natural number equal to or greater than one) input line data, which are line data included in the current frame data, into the memory area of the memory device 150 and sequentially read zero-th output line data to n-th output line data that are line data of previous frame data stored in the same memory area, from the memory area. Here, the current frame data may mean frame data that is being received from the host 10 by the data processing device 140 in a current frame period defined as a high voltage level period of the vertical synchronization signal V-sync as in FIG. 3.

The previous frame data may mean frame data stored in the memory area of the memory device 150 by the data processing device 140 in a previous frame period that is a frame period just before the current frame period.

The zero-th input line data may mean first line data of the current frame data, and the n-th input line data may mean last line data of the current frame data.

The zero-th output line data may mean first line data of the previous frame data, and the n-th output line data may mean last line date of the previous frame data.

On the other hand, in the embodiment, the data processing device 140 may include the following configuration.

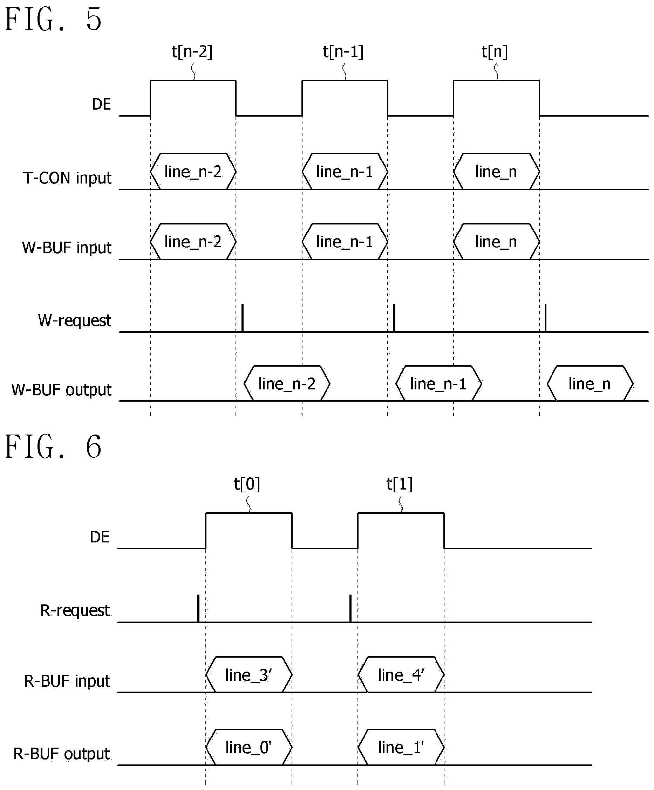

FIG. 2 is a configuration diagram of the data processing device 140 according to the embodiment. FIG. 3 is a diagram illustrating an operation method of a memory controller according to the embodiment. FIG. 4 is a diagram illustrating an operation of a writing line buffer in an early portion of the current frame period. FIG. 5 is a diagram illustrating an operation of the writing line buffer in a latter portion of the current frame period. FIGS. 6 to 8 are diagrams illustrating an operation of a reading line buffer in an early portion of the current frame period.

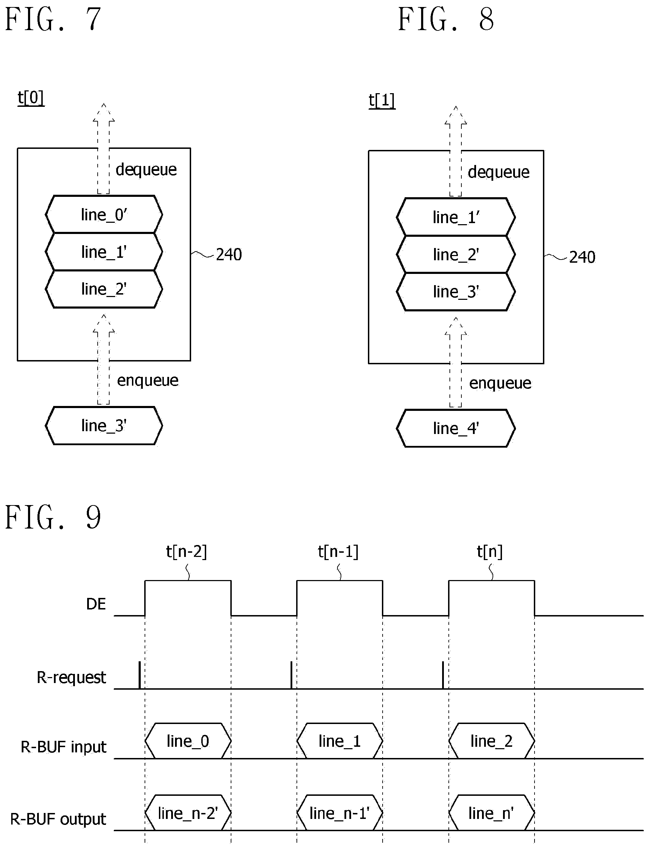

FIGS. 9 to 12 are diagrams illustrating an operation of the reading line buffer in a latter portion of the current frame period.

First, referring to FIG. 2, the data processing device 140 may include an image processing circuit 210, a memory controller 220, a writing line buffer 230, and a reading line buffer 240.

The image processing circuit 210 may receive the image data IMG from the host 10, correct the image data IMG, convert the image data IMG into the image data IMG' in a form capable of being processed in the data driving device 120, and output the image data IMG' to the data driving device 120.

In the embodiment, the image processing circuit 210 may receive the image data IMG in synchronization with the vertical synchronization signal V-sync and the data enable signal DE input from the host 10.

In other words, the image processing circuit 210 receives the current frame data of the image data IMG from the host 10 in the current frame period defined as a high voltage level period of the vertical synchronization signal V-sync as in FIG. 3. Here, the image processing circuit 210 may sequentially receive the zero-th input line data to the n-th input line data that are the line data of the current frame data, in conformity with a high voltage level period of the data enable signal DE. Here, the high voltage level period of the data enable signal DE may be defined as a data enable period.

The image processing circuit 210 may transfer the zero-th input line data to the n-th input line data to the memory controller 220 in conformity with the data enable period. Here, the data enable signal DE is a signal that is input from the host 10 in the current frame period as in FIG. 3.

On the other hand, the image processing circuit 210 may sequentially receive zero-th output line data to n-th output line data transferred from the memory controller 220 when transferring the zero-th input line data to the n-th input line data to the memory controller 220. The zero-th output line data to the n-th output line data may be transferred to the image processing circuit 210 in conformity with the data enable period. Here, the output line data means the line data of the previous frame data.

The image processing circuit 210 may correct one or more of the zero-th output line data to the n-th output line data. The zero-th output line data to the n-th output line data may be converted into the image data IMG' in a form capable of being processed in the data driving device 120 and may be output to the data driving device 120. In other words, the image processing circuit 210 may convert the previous frame data into the image data IMG' in the current frame period and may output the image data IMG' to the data driving device 120.

The memory controller 220 receives the input line data transferred from the image processing circuit 210 in conformity with the data enable period. Then, the memory controller 220 performs control such that the writing line buffer 230 temporarily stores the received input line data.

In other words, the memory controller 220 receives the input line data transferred from the image processing circuit 210 in the data enable period and temporarily stores the input line data in the writing line buffer 230.

When the data enable signal DE is switched to a low voltage level, the memory controller 220 transfers a write request signal W-request to the memory device 150 and moves the input line data temporarily stored in the writing line buffer 230 to the memory area of the memory device 150. Here, moving the input line data to the memory area of the memory device 150 may be interpreted as the memory controller 220 writing the input line data to the memory area.

For example, the memory controller 220 receives zero-th input line data line_0 transferred from the image processing circuit 210 in a zero-th data enable period t[0] as in FIG. 4 and temporarily stores the zero-th input line data line_0 in the writing line buffer 230 (see FIG. 4 for W-BUF input).

When the data enable signal DE is switched to the low voltage level immediately after the zero-th data enable period t[0], the memory controller 220 transfers the write request signal W-request to the memory device 150 and moves the zero-th input line data line_0 stored in the writing line buffer 230 to the memory area of the memory device 150 (see FIG. 4 for W-BUF output).

On the other hand, the memory controller 220 receives first input line data line_1 transferred from the image processing circuit 210 in a first data enable period t[1] and temporarily stores the first input line data line_1 in the writing line buffer 230. Here, the first data enable period t[1] may be reached while the memory controller 220 is moving the zero-th input line data line_0 to the memory area of the memory device 150.

When the data enable signal DE is switched to the low voltage level immediately after the first data enable period t[1], the memory controller 220 transfers the write request signal W-request to the memory device 150 again and moves the first input line data line_1 temporarily stored in the writing line buffer 230 to the memory area of the memory device 150.

With the configuration as described above, the memory controller 220 may sequentially write the zero-th input line data line_0 to n-th input line data line_n of the current frame data to the memory area of the memory device 150 in the current frame period.

In other words, the memory controller 220 temporarily stores (n-2)th input line data line_n-2 in the writing line buffer 230 in an (n-2)th data enable period t[n-2] of the current frame period as in FIG. 5 and moves the (n-2)th input line data line_n-2 from the writing line buffer 230 to the memory area of the memory device 150 immediately after the (n-2)th data enable period t[n-2].

The memory controller 220 temporarily stores (n-1)th input line data line_n-1 in the writing line buffer 230 in an (n-1)th data enable period t[n-1] of the current frame period and moves the (n-1)th input line data line_n-1 from the writing line buffer 230 to the memory area of the memory device 150 immediately after the (n-1)th data enable period t[n-1].

Finally, the memory controller 220 temporarily stores the n-th input line data line_n in the writing line buffer 230 in an n-th data enable period t[n] of the current frame period and moves the n-th input line data line_n from the writing line buffer 230 to the memory area of the memory device 150 immediately after the n-th data enable period t[n].

On the other hand, the memory controller 220 may transfer the zero-th output line data to the n-th output line data of the previous frame data to the image processing circuit 210 in the current frame period.

In the embodiment, the memory controller 220 may write the current frame data to the memory area and read the previous frame data from the same memory area.

Specifically, in the latter portion of the previous frame period, the memory controller 220 may sequentially move the zero-th output line data to k-th (where k is a natural number greater than or equal to one and less than n) output line data among the zero-th output line data to the n-th output line data stored in the memory area of the memory device 150 to the reading line buffer 240. Here, moving the output line data to the reading line buffer 240 may be interpreted as the memory controller 220 reading the output line data from the memory area.

On the other hand, in the early portion of the current frame period, the memory controller 220 may move the zero-th input line data stored in the writing line buffer 230 to the memory area of the memory device 150. Here, the memory controller 220 may write the zero-th input line data to a memory address (for example, a zero-th memory address) in the memory area of the memory device 150 where the zero-th output line data is read.

In other words, in the latter portion of the previous frame period, the memory controller 220 may move the zero-th output line data to the k-th output line data from the memory area of the memory device 150 to the reading line buffer 240 in advance. For this reason, memory addresses in the memory area of the memory device 150 where the zero-th output line data to the k-th output line data are read are memory addresses where overwriting of data is enabled. In other words, the memory addresses in the memory area of the memory device 150 where the zero-th output line data to the k-th output line data are stored are memory addresses where overwriting is enabled.

In the early portion of the current frame period, the memory controller 220 may move the zero-th input line data to one memory addresses among the memory addresses in the memory area where overwriting is enabled. Here, the reading line buffer 240 may have a capacity capable of storing (k+1) pieces of output line data.

The memory controller 220 may secure the memory addresses in the memory area of the memory device 150 where overwriting is enabled, in the latter portion of the previous frame period, and moves the zero-th input line data to the memory address where overwriting is enabled, in the current frame period.

On the other hand, in storing the input line data in the writing line buffer 230, the memory controller 220 may extract the output line data first moved among the output line data moved to the reading line buffer 240, from the reading line buffer 240 and transfer the output line data to the image processing circuit 210.

In other words, the memory controller 220 may extract the output line data from the reading line buffer 240 in a first in first out (FIFO) manner.

For example, when the reading line buffer 240 has a capacity capable of storing three pieces of output line data, the memory controller 220 may move zero-th output line data line_0' to second output line data line_2' from the memory area of the memory device 150 to the reading line buffer 240 before the zero-th data enable period, that is, in a latter portion of a frame period just before as in FIGS. 6 and 7.

In the current frame period, the memory controller 220 transfers a read request signal R-request to the memory device 150 just before the zero-th data enable period t[0]. With this, the memory controller 220 may move third output line data line_3' stored in the memory area of the memory device 150 to the reading line buffer 240 in the zero-th data enable period t[0] (R-BUF input). Then, the memory controller 220 may extract the zero-th output line data line_0' first moved among the zero-th output line data line_0' to the second output line data line 2' moved to the reading line buffer 240 (R-BUF output) and transfer the zero-th output line data line_0' to the image processing circuit 210 in the zero-th data enable period t[0].

Here, the reading line buffer may be a memory having a queue structure. Accordingly, in the zero-th data enable period t[0], the zero-th output line data line_0' may dequeue at the front of the reading line buffer 240 as in FIG. 7 and the third output line data line_3' may enqueue at the rear of the reading line buffer 240.

After the zero-th output line data line_0' is transferred to the image processing circuit 210 in the zero-th data enable period t[0] of the current frame period, the memory controller 220 transfers the read request signal R-request to the memory device 150 again just before the first data enable period t[1].

With this, in the first data enable period t[1], the memory controller 220 may move fourth output line data line_4' stored in the memory area of the memory device 150 to the reading line buffer 240 (R-BUF input). Then, in the first data enable period t[1], the memory controller 220 may extract first output line data line_1' first moved among the first output line data line_1' to the third output line data line_3' moved to the reading line buffer 240 (R-BUF output) and transfer the first output line data line_1' to the image processing circuit 210.

In the first data enable period t[1], the first output line data line_1' may dequeue at the front of the reading line buffer 240 as in FIG. 8 and the fourth output line data line_4' may enqueue at the rear of the reading line buffer 240.

With the configuration as above, the memory controller 220 may sequentially transfer the output line data of the previous frame data to the image processing circuit 210 in the current frame period.

Here, in sequentially transferring the (n-k)th output line data to the n-th output line data to the image processing circuit 210 in the latter portion of the current frame period, memory controller 220 may move the zero-th input line data line_0 to the k-th input line data line_k from the memory area of the memory device 150 to the reading line buffer 240 in advance. In other words, the zero-th input line data line_0 to the k-th input line data line_k stored in the memory area of the memory device 150 may be read to the reading line buffer 240 in advance.

The zero-th input line data line_0 to the k-th input line data line_k read to the reading line buffer 240 in advance are line data of the current frame data that will be transferred to the image processing circuit 210 in an early portion of a next frame period. The zero-th input line data line_0 to the k-th input line data line_k are written to the memory area of the memory device 150 in the early portion of the current frame period.

For example, when the reading line buffer 240 has a capacity capable of storing three pieces of output line data, and k is two, the memory controller 220 transfers the read request signal R-request to the memory device 150 just before the (n-2)th data enable period t[n-2] of the current frame period as in FIG. 9.

With this, in the (n-2)th data enable period t[n-2], the memory controller 220 may move the zero-th input line data line_0 of the current frame data stored in the memory area of the memory device 150 to the reading line buffer 240 (R-BUF input).

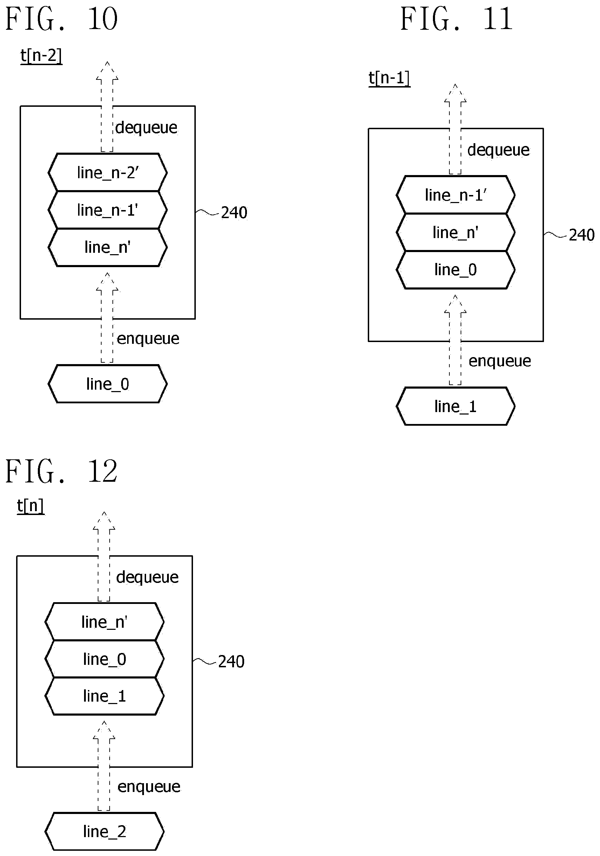

In the (n-2)th data enable period t[n-2], as in FIGS. 9 and 10, the memory controller 220 may extract (n-2)th output line data line_n-2' first moved among the (n-2)th output line data line_n-2' to n-th output line data line_n' moved to the reading line buffer 240 (R-BUF output) and transfer the (n-2)th output line data line_n-2' to the image processing circuit 210. Here, the memory controller 220 may move the (n-2)th output line data line_n-2' to the reading line buffer 240 in an (n-5)th data enable period t[n-5], and move the (n-1)th output line data line_n-1' to the reading line buffer 240 in an (n-4)th data enable period t[n-4].

The memory controller 220 may reset a read address R-address that is a memory address for reading output line data, after moving the n-th output line data line_n' to the reading line buffer 240 in an (n-3)th data enable period t[n-3].

In other words, the memory controller 220 may complete reading of the n-th output line data line_n' stored in a last address of the memory area in the (n-3)th data enable period t[n-3] that is the latter portion of the current frame period, and may reset the read address of the output line data to a first memory address (for example, the zero-th memory address) of the memory area. Here, the n-th output line data line_n' is last line data of the previous frame data.

After the read address of the output line data is reset as above, in the (n-2)th data enable period t[n-2] of the current frame period, the memory controller 220 may move the zero-th input line data line_0 of the current frame data stored in the memory area of the memory device 150 to the reading line buffer 240. Further, in the (n-2)th data enable period t[n-2], the memory controller 220 may extract the (n-2)th output line data line_n-2' from the reading line buffer 240 and transfer the (n-2)th output line data line_n-2' to the image processing circuit 210.

In the (n-2)th data enable period t[n-2], the (n-2)th output line data line_n-2' may dequeue at the front of the reading line buffer 240 as in FIG. 10 and the zero-th input line data line_0 may enqueue at the rear of the reading line buffer 240.

On the other hand, the memory controller 220 transfers the read request signal R-request to the memory device 150 just before the (n-1)th data enable period t[n-1] as in FIG. 9.

With this, in the (n-1)th data enable period t[n-1], the memory controller 220 may move the first input line data line_1 of the current frame data stored in the memory area of the memory device 150 to the reading line buffer 240 (R-BUF input).

In the (n-1)th data enable period t[n-1], as in FIGS. 9 and 11, the memory controller 220 may extract the (n-1)th output line data line_n-1' first moved among the (n-1)th output line data line_n-1' to the zero-th input line data line_0 moved to the reading line buffer 240 (R-BUF output) and transfer the (n-1)th output line data line_n-1' to the image processing circuit 210.

In the (n-1)th data enable period t[n-1], the (n-1)th output line data line_n-1' may dequeue at the front of the reading line buffer 240 as in and the first input line data line_1 may enqueue at the rear of the reading line buffer 240.

On the other hand, as shown in FIGS. 3 and 9, the memory controller 220 transfers the read request signal R-request to the memory device 150 just before the n-th data enable period t[n] that is a last data enable period of the current frame period.

Thereby, in the n-th data enable period t[n], the memory controller 220 may move the second input line data line_2 of the current frame data stored in the memory area of the memory device 150 to the reading line buffer 240 (R-BUF).

In the n-th data enable period t[n], as in FIGS. 9 and 12, the memory controller 220 may extract the n-th output line data line_n' first moved among the n-th output line data line_n' to the first input line data line_1 moved to the reading line buffer 240 (R-BUF output) and transfer the n-th output line data line_n' to the image processing circuit 210.

In the n-th data enable period t[n], the n-th output line data line_n' may dequeue at the front of the reading line buffer 240 as in FIG. 12 and the second input line data line_2 may enqueue at the rear of the reading line buffer 240.

With the configuration as above, the zero-th input line data line_0 to the second input line data line_2 of the current frame data may be moved from the memory area of the memory device 150 to the reading line buffer 240 in advance in the latter portion of the current frame period. Then, when the vertical synchronization signal V-sync is switched from the high voltage level to the low voltage level, the current frame period may end.

Here, the zero-th input line data line_0 to the second input line data line_2 may be output to the data driving device 120 via the image processing circuit 210 in an early portion of a next frame period that is a frame period immediately after the current frame period.

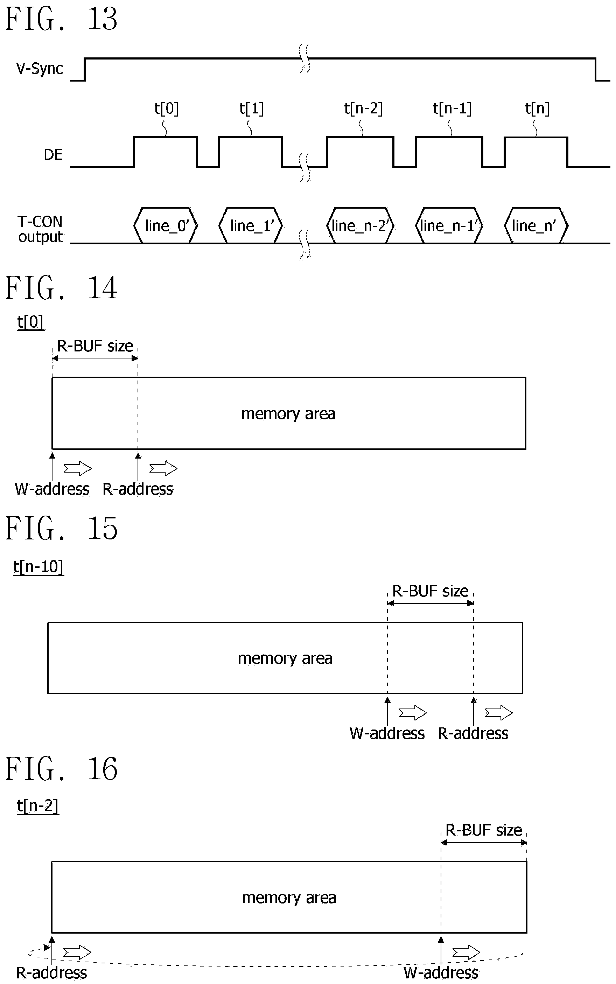

On the other hand, in the current frame period, as in FIG. 13, the zero-th output line data line_0' to the n-th output line data line_n' may be output to the data driving device 120 in conformity with the data enable periods t[0] to t[n] of the data enable signal DE.

As above, in the embodiment, the data processing device 140 may read a front portion of the previous frame data from the memory area in advance before writing the current frame data to the memory area of the memory device 150. Accordingly, the memory addresses where the front portion of the current frame data can be overwritten can be secured in the memory area.

With the configuration as above, in the embodiment, writing of the current frame data and reading of the previous frame data can be performed together in the memory area of the memory device 150, that is, in one memory area.

Here, the number of memory addresses in the memory area where overwriting is enabled may be the same as the storage capacity of the reading line buffer 240.

For example, when the reading line buffer 240 has a capacity capable of storing three pieces of output line data, the zero-th output line data line_0' to the second output line data line_2' stored in the zero-th memory address to the second memory address of the memory area may be read to the reading line buffer 240 in advance. For this reason, the write address W-address may be the zero-th memory address in the zero-th data enable period t[0]. The read address R-address may be the second memory address.

In other words, in the zero-th data enable period t[0], that is, in the early portion of the current frame period, writing of the current frame data and reading of the previous frame data can be advanced in a state in which the write address W-address and the read address R-address are spaced by the storage capacity (R-BUF size) of the reading line buffer 240 as in FIG. 14. Also in an (n-10) data enable period t[n-10], that is, in a mid-late portion of the current frame period, writing of the current frame data and reading of the previous frame data can be advanced in a state in which the write address W-address and the read address R-address are spaced by the storage capacity (R-BUF size) of the reading line buffer 240 as in FIG. 14.

In the (n-2)th data enable period t[n-2], that is, in the latter portion of the current frame period, writing of the current frame data and reading of the previous frame data can be advanced in a state in which the read address R-address is reset to the zero-th memory address of the memory area.

Since writing of the current frame data and reading of the previous frame data are advanced in a state in which the write address W-address and the read address R-address are spaced in one memory area as above, it is possible to prevent a situation in which the input line data of the current frame data is stored in a memory address where the output line data of the previous frame data is not read. In other words, it is possible to prevent the loss of the output line data.

As described above, since the data processing device 140 performs reading of the previous frame data and writing of the current frame data in one memory area of the memory device 150, the capacity and size of the memory device 150 can be reduced.

Hereinafter, a process in which the data processing device 140 writes the current frame data to the memory device 150 in the current frame period and a process in which the data processing device 140 reads the previous frame data from the memory device 150 in the current frame period will be described.

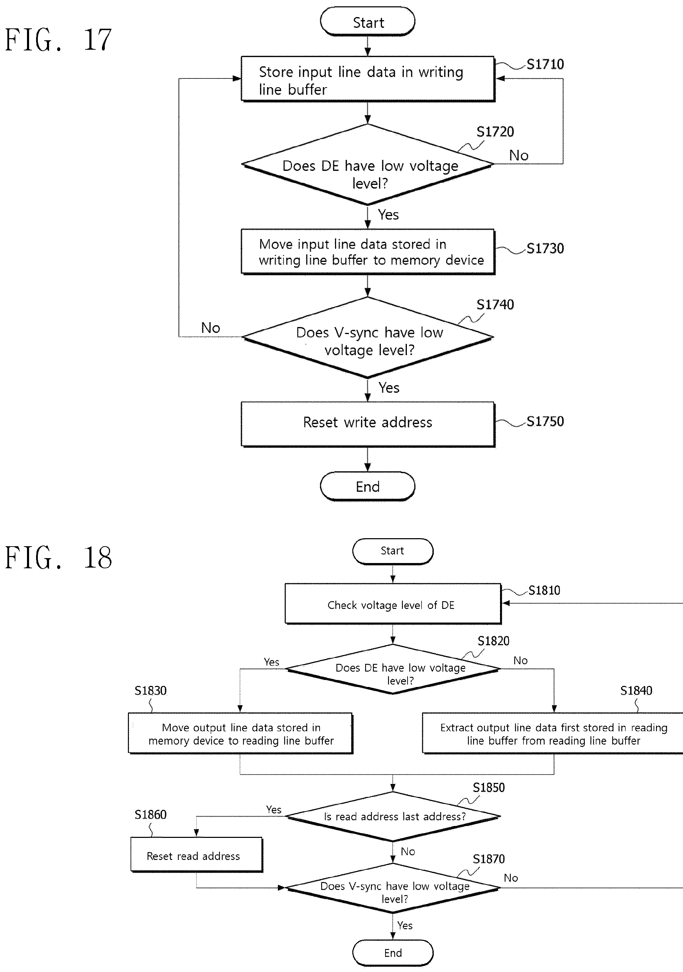

FIG. 17 is a flowchart illustrating a process in which the data processing device according to the embodiment writes line data to the memory area of the memory device.

The data processing device 140 temporarily stores the input line data of the current frame data input from the host 10 in the writing line buffer 230 in the current frame period defined as the high voltage level period of the vertical synchronization signal (S1710). Here, the data processing device 140 may temporarily store the input line data in the writing line buffer 230 in conformity with the high voltage level period of the data enable signal DE input from host 10 in the current frame period.

When the data enable signal DE is switched from the high voltage level to the low voltage level, the data processing device 140 moves the input line data temporarily stored in the writing line buffer 230 to the memory area of the memory device 150 (S1720 and S1730). In other words, the input line data is written to the memory area of the memory device 150.

Steps S1710 to S1730 may be repeated in a period during which the vertical synchronization signal V-sync has the high voltage level, and when the vertical synchronization signal V-sync is switched to the low voltage level, the data processing device 140 may reset the write address W-address of the input line data to the first memory address (for example, the zero-th memory address) of the memory area and may end the process of writing the input line data in the current frame period (S1740 and S1750).

FIG. 18 is a flowchart illustrating a process in which the data processing device according to the embodiment reads the line data from the memory area of the memory device.

When the data enable signal DE has the low voltage level, the data processing device 140 may transfer the read request signal R-request to the memory device 150 in the current frame period defined as the high voltage level period of the vertical synchronization signal (S1810 and S1820).

With this, the output line data of the previous frame data stored in the memory area of the memory device 150 may be moved to the reading line buffer 240 (S1830). In other words, the output line data is read from the memory area of the memory device 150 to the reading line buffer 240.

When the data enable signal D has the high voltage level in step S1820, the data processing device 140 may extract the output line data first stored in the reading line buffer 240 (S1840). The data processing device 140 may perform step S1830 and step S1840 in conformity with the high voltage level period of the data enable signal D.

On the other hand, when the data processing device 140 writes the output line data to the last memory address of the memory area in step S1830, that is, when the read address is the last memory address, the data processing device 140 may reset the read address R-address of the output line data to the first memory address (for example, the zero-th memory address) of the memory area (S1850 and S1860).

The data processing device 140 may repeatedly perform steps S1810 to S1840 in a period during which the vertical synchronization signal V-sync has the high voltage level, and may end the process of reading the output line data in the current frame period when the vertical synchronization signal V-sync is switched to the low voltage level (S1870).

In the embodiment, the data processing device 140 may sequentially read the zero-th output line data to the k-th output line data of the previous frame data stored in the memory area of the memory device 150 to the reading line buffer 240 before step S1810, that is, in the latter portion of the previous frame period. In other words, the data processing device 140 may sequentially move the zero-th output line data to the k-th output line data to the reading line buffer 240 in the latter portion of the previous frame period.

On the other hand, the data processing device 140 may perform step S1710 of FIG. 17 in parallel in performing step S1840.

For example, when the output line data extracted from the reading line buffer 240 in step S1840 is the zero-th output line data, the data processing device 140 may temporarily store the zero-th input line data included in the current frame data in the writing line buffer 230.

In other words, in step S1840, the data processing device 140 may temporarily store the zero-th input line data in the writing line buffer 230, and extract the zero-th output line data from the reading line buffer 240.

Subsequently, the data processing device 140 may write the zero-th input line data stored in the writing line buffer 230 to the memory area of the memory device 150. Here, the data processing device 140 may write the zero-th input line data to a memory address (for example, a zero-th memory address) in the memory area where the zero-th output line data is read.

On the other hand, the data processing device 140 may read the (k+1)th output line data stored in the memory area to the reading line buffer 240 before writing the zero-th input line data to the memory area.

After step S1860, that is, the read address of the output line data is reset, the data processing device 140 may read the zero-th input line data to the reading line buffer 240.

## Claims

1. A data processing device (140) comprising:
a writing line buffer (230) configured to temporarily store zero-th input line data included in current frame data during a current frame period defined as a high voltage level period of a vertical synchronization signal;
a reading line buffer (240) configured to output, in a state in which zero-th output line data to k-th (where k is a natural number equal to or greater than one) output line data included in previous frame data are stored in advance, the zero-th output line data when the writing line buffer (230) temporarily stores the zero-th input line data in the current frame period; and
a memory controller (220) configured to sequentially read the zero-th output line data to the k-th output line data stored in a memory area of a memory device (150) to the reading line buffer (240) and then write the zero-th input line data stored in the writing line buffer (230) to the memory area.

2. The data processing device according to claim 1, wherein the memory controller (220) is configured to sequentially read the zero-th output line data to the k-th output line data to the reading line buffer (240) in a latter portion of a previous frame period that is a frame period just before the current frame period.

3. The data processing device according to claim 1 or 2, wherein the memory controller (220) is configured to temporarily store the zero-th input line data to the writing line buffer (230) in a high voltage level period of a data enable signal input in the current frame period and write the zero-th input line data temporarily stored in the writing line buffer (230) to the memory area when the data enable signal is switched to a low voltage level.

4. The data processing device according to any one of the preceding claims, wherein the memory controller (220) is configured to write the zero-th input line data to a memory address in the memory area where the zero-th output line data is read.

5. The data processing device according to any one of the preceding claims, wherein the memory controller (220) is configured to read (k+1)th output line data stored in the memory area to the reading line buffer (240) in outputting the zero-th output line data from the reading line buffer (240).

6. The data processing device according to claim 5, wherein the reading line buffer (240) is a memory having a queue structure, and the zero-th output line data dequeues at a front, and the (k+1)th output line data enqueues at a rear.

7. A memory control method of a data processing device comprising:
temporarily storing (S1710) zero-th input line data of current frame data in a writing line buffer (230) in a zero-th data enable period of a current frame period;
in a state in which zero-th output line data to k-th (where k is a natural number equal to or greater than one) output line data of previous frame data stored in a memory area of a memory device (150) are read to a reading line buffer (240) in advance, extracting the zero-th output line data from the reading line buffer in the zero-th data enable period;
reading (k+1) pieces of output line data stored in the memory area to the reading line buffer in the zero-th data enable period; and
writing the zero-th input line data temporarily stored in the writing line buffer (230) to the memory area, the zero-th input line data being written to one address among memory addresses in the memory area from which the zero-th output line data to the k-th output line data are read in advance.

8. The memory control method of a data processing device according to claim 7, wherein, in the writing, the data processing device (140) writes the zero-th input line data to a memory address in the memory area where the zero-th output line data is read.

9. The memory control method of a data processing device according to claim 7 or 8, further comprising, after the writing, reading the zero-th input line data stored in the one memory address to the reading line buffer (240) in a latter portion of the current frame period.

10. The memory control method of a data processing device according to claim 9, wherein the data processing device (140) reads the zero-th input line data to the reading line buffer (240) after resetting a read address of the memory area.

11. A display device comprising:
a panel (110);
a data driving device (120) configured to transmit a data signal to the panel (110);
a gate driving device (130) configured to transmit a gate signal to the panel (110), and
a data processing device (140) as claimed in any one of the preceding claims 1-6 and controlling the data driving device (120) and the gate driving device (130).
